(19) Europäisches Patentamt

European Patent Office

Office européen des brevets

(11) Numéro de publication: **0 322 960 B1**

(12) **FASCICULE DE BREVET EUROPEEN**

(45) Date de publication de fascicule du brevet: **06.05.92**    (51) Int. Cl.⁵: **H01L 29/72**, H01L 21/90

(21) Numéro de dépôt: **88202927.5**

(22) Date de dépôt: **19.12.88**

(54) **Procédé de réalisation d'un dispositif semi-conducteur incluant au moins un transistor bipolaire à hétérojonction.**

(30) Priorité: **30.12.87 FR 8718392**

(43) Date de publication de la demande:
**05.07.89 Bulletin   89/27**

(45) Mention de la délivrance du brevet:
**06.05.92 Bulletin   92/19**

(84) Etats contractants désignés:
**DE FR GB NL**

(56) Documents cités:
**EP-A- 0 184 016**

**PATENT ABSTRACTS OF JAPAN, vol. 12, no. 89 (E-592)[2936], 23 mars 1988, page 108 E 592; & JP-A-62 224 073**

**INTERNATIONAL ELECTRON DEVICES MEETING, Washington, DC, 1-4 décembre 1985, pages 328-331, IEEE, New York, US; T. IZAWA et al.: "AlGaAs/GaAs heterojunction bipolar transistors"**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB NL**

(72) Inventeur: **Selle, Daniel**
**Société Civile S.P.I.D. 209 rue de l'Université**
**F-75007 Paris(FR)**
Inventeur: **Boissenot, Philippe**
**Société Civile S.P.I.D. 209 rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

EP 0 322 960 B1

GaAs IC SYMPOSIUM - IEEE GALLIUM ARSE-NIDE INTEGRATED CIRCUIT SYMPOSIUM, Technical Digest 1985, Monterey, 12-14 novembre 1985, pages 53-56, IEEE, New York, US; T. OHSHIMA et al.: "A self-aligned GaAs/AlGaAs heterojunction bipolar transistor with V-groove isolated planar structure"

IEEE ELECTRON DEVICE LETTERS, vol. EDL-7, no. 1, janvier 1986, pages 8-10, IEEE, New York, US; M.F. CHANG et al.: "GaAs/(GaAl)As heterojunction bipolar transistors using a self-aligned substitutional emitter process"

APPLIED PHYSICS LETTERS, vol. 49, no. 19, 10 novembre 1986, pages 1278-1280, American Institute of Physics, New York, US; K. TAIRA et al.: "Emitter grading in AlGaAs/GaAs heterojunction bipolar transistor grown by metalorganic chemical vapor deposition"

# Description

L'invention concerne un procédé de réalisation d'un dispositif semiconducteur du type transistor bipolaire à hétérojonction à structure planaire, ce procédé comprenant au moins la réalisation d'une structure comportant successivement au moins une couche de collecteur d'un premier type de conductivité, une couche de base du second type de conductivité opposé au premier, une couche d'émetteur du premier type de conductivité et une couche de contact fortement dopée du premier type de conductivité.

L'invention trouve son application dans la réalisation de circuits intégrés sur matériaux du groupe III-V et notamment sur arséniure de gallium, incluant des transistors bipolaires à hétérojonction.

Un transistor bipolaire à hétérojonction, de structure planaire, est déjà connu de la publication intitulée "A Fully Planar-Heterojunction Bipolar Transistor" par John W. TULLY et alii dans "IEEE Electron Device Letters, Vol.EDL 7 n°11, Nov.1986", pp.615-617.

Ce document décrit un transistor formé sur un substrat semiconducteur de type de conductivité $n^+$. Ce transistor comprend une première couche de GaAs de type $n^+$, une seconde couche de GaAs de type n et une couche de base de type $p^+$ formée par implantation localisée, dans la partie supérieure de la couche de GaAs de type n.

Ce transistor comprend ensuite deux couches supérieures, la première en GaAlAs de type n pour former l'émetteur et la seconde en GaAs de type $n^+$ pour permettre la prise des contacts. Les régions de base sont constituées par des caissons $p^+$ reliant les contacts de base à la couche implantée $p^+$.

Le procédé de réalisation de ce transistor commence par la croissance épitaxiale des couches collecteur $n^+$ et n par la méthode dite MOCVD. La région de base est définie par un masque en photorésist et est implantée sélectivement au moyen d'ions $Zn^+$. Après élimination de la couche de photorésist le substrat est réinséré dans le réacteur MOCVD pour un recuit à haute température. Cette opération est suivie immédiatement par la croissance de la couche d'émetteur de type n en GaAlAs et la couche de contact de type $n^+$ en GaAs. La couche d'émetteur de composition $Ga_{1-x}Al_xAs$ montre un gradient de la concentration x en Al. Dans les premiers 50 nm la concentration x est comprise entre 0 et 0,30. Puis le reste de la couche émetteur est réalisé avec x = 0,30 en Al. A la suite le dispositif est couvert de $SiO_2$ puis d'une couche d'Al, d'une épaisseur de chacune 400 nm. Les contacts de base sont définis par photolithographie et l'aluminium est gravé chimiquement, puis la couche de $SiO_2$ est gravée par plasma. Ce procédé résulte en une gravure de $SiO_2$ plus importante que celle de Al, lequel fait une saillie au-dessus de $SiO_2$. Ce procédé sert ultérieurement au LIFT-OFF de l'aluminium. La couche supérieure de GaAs est ainsi découverte et des ions $Zn^+$ sont implantés dans les ouvertures de $Al/SiO_2$. Puis, un métal apte à former un contact de type p tel que Mo/Cr est évaporé. A ce point du procédé, l'aluminium est éliminé chimiquement, ce qui permet d'éliminer l'excès de Mo/Cr. Après le LIFT-OFF, l'échantillon est recuit à haute température pour activer l'implantation $p^+$. Enfin, les contacts d'émetteur et de collecteur définis par photolithographie, sont réalisés simultanément au moyen d'un métallisation de AuGe/Ni/Au, le métal en excès est éliminé et ses contacts sont recuits.

Dans ce procédé connu, les métallisations d'émetteur et de collecteur sont "simplement alignées" par rapport à la métallisation de base. Ce type d'alignement conduit à une précision difficilement meilleure que le micron. Il en résulte que les espacements entre les métallisations d'émetteur et de base, et les espacements entre les métallisations de collecteur et de base sont au moins égaux au micron. Dans ces conditions les transistors présentent des dimensions trop importantes pour être compatibles avec les performances recherchées pour l'application envisagée.

Au contraire, la présente invention propose un procédé de réalisation qui permet d'obtenir un "autoalignement" des contacts d'émetteur et de collecteur sur les contacts de base, d'où il résulte la possibilité de réaliser :

- un émetteur de dimension submicronique,
- des intervalles entre électrodes extrêmement petits et de dimensions extrêmement précises.

Ces avantages sont dus au fait que le procédé selon l'invention met en oeuvre, pour la définition des régions de base, un procédé fondé sur la formation d'espaceurs qui est extrêmement précis et répétitif.

Il en résulte que les transistors obtenus selon l'invention :

- sont extrêmement compacts, donc de très petites dimensions et permettent une intégration à haute densité,
- montrent des dimensions très répétitives d'un transistor à l'autre et donc une très faible dispersion de leur cactéristiques.

Ce but est atteint au moyen d'un procédé tel que décrit dans le préambule et qui comprend en outre les étapes :

a/ dépôt d'une couche de nitrure de silicium ($Si_3N_4$),

b/ mise en place d'un masque $MK_2$ délimitant des ouvertures en surplomb des régions de base et gravure de la couche de nitrure de

silicium (Si$_3$N$_4$) à travers ces ouvertures jusqu'à mettre à nu la surface de la couche de contact, par une méthode permettant d'obtenir des flancs de gravure perpendiculaires au plan des couches, formant ainsi dans la couche de nitrure des ouvertures éloignées l'une de l'autre,

c/ implantation localisée d'ions du second type de conductivité à travers les ouvertures de la couche de nitrure, avec une énergie suffisante pour atteindre la couche de base, de manière à former des caissons du second type de conductivité reliant la couche de base à la surface de la couche de contact,

d/ dépôt d'une couche métallique qui s'établit dans les ouvertures ainsi que sur les parties restantes de la couche de nitrure (Si$_3$N$_4$),

e/ réalisation d'une couche de silice (SiO$_2$) très épaisse, puis planarisation, par une méthode connue en soi, du dispositif ainsi obtenu jusqu'au niveau supérieur de la couche de nitrure (Si$_3$N$_4$), par la gravure ionique réactive (RIE) et l'usinage ionique,

f/ gravure sélective des parties restantes de la couche de nitrure (Si$_3$N$_4$) pour conserver des plots de silice (SiO$_2$) couvrant les métallisations de base,

g/ dépôt d'une nouvelle couche de nitrure de silicium (Si$_3$N$_4$) et formation par une méthode connue en soi, d'espaceurs formés dans cette nouvelle couche de nitrure, espaceurs appuyés contre les flancs des plots de silice (SiO$_2$), destinés à réduire l'écart entre ces plots de silice formant ainsi une ouverture qui définit la largeur du contact d'émetteur, ces espaceurs définissant aussi la distance des électrodes de collecteur, base et émetteur entre elles,

h/ dépôt d'une couche métallique propre à former les contacts d'émetteur et de collecteur, les plots de silice (SiO$_2$) et les espaceurs servant de masque, puis élimination de ces parties diélectriques,

i/ implantation ionique localisée entre les contacts de collecteur, base, et émetteur servant de masques, d'espèces propres à former des caissons isolants entre ces électrodes avec une énergie permettant d'atteindre la surface supérieure de la couche d'émetteur du premier type de conductivité.

L'invention sera mieux comprise au moyen de la description suivante illustrée par les figures annexées dont :

- la figure 1a qui représente en coupe schématique le transistor bipolaire à hétérojonction planaire obtenu par le procédé selon l'invention,
- la figure 1b qui représente ce transistor vu du dessus,

- les figures 2a à 2n qui illustrent les différentes étapes du procédé de réalisation selon l'invention,
- la figure 3 qui montre la méthode de formation des espaceurs,
- la figure 4 qui illustre une variante du procédé selon l'invention.

Tel que représenté sur la figure 1a dans un exemple de mise en oeuvre, le dispositif selon l'invention comprend d'abord, réalisée sur un substrat semi-isolant 100 en un matériau du groupe III-V, une couche 1 en arséniure de gallium (GaAs) de type de conductivité n$^+$.

Ce transistor comprend ensuite une couche 2 d'arséniure de gallium (GaAs) de type de conductivité n. Les couches 1 et 2 forment les couches collecteur.

Ce transistor comprend en outre une couche 3 d'arséniure de gallium et d'aluminium (GaAlAs) de type de conductivité n, ou couche émetteur.

En surface de la couche 3 on trouve, pour permettre la prise des contacts collecteurs et émetteurs, une couche épitaxiale 4 d'arséniure de gallium (GaAs) de type de conductivité n$^+$. Cette couche 4 de type n$^+$ est reliée à la couche collecteur 1 de type n$^+$, par des caissons 20 de type n$^+$, disposés sous les contacts collecteurs C$_1$.

En surface de la couche 4 sont réalisés les contacts métalliques de collecteur C, de base B et d'émetteur E.

Formés dans les couches 3 et 4, on trouve sous les contacts de base B, des caissons 30 de type de conductivité p$^+$ reliés par une couche 31 réalisée au niveau de la surface de la couche 2 également de type de conductivité p$^+$.

Le contact de base est réalisé au moyen de métaux tels que AuMn ou AuBe. Les contacts d'émetteur et de collecteur au moyen de métaux tels que : AuGe/Ni.

L'isolation entre les différentes électrodes est obtenue au moyen de caissons 110.

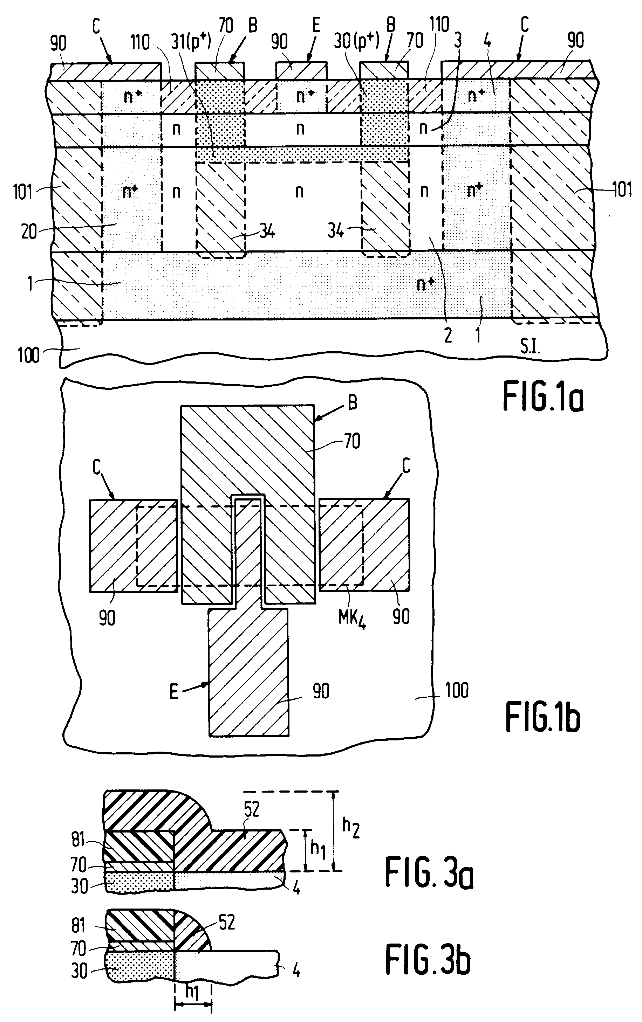

Ce transistor présente l'avantage d'être absolument planaire. Comme illustré par la figure 1b, vu du dessus, il montre en outre une structure interdigitée, à deux doigts de base B, et un doigt d'émetteur E. Il montre aussi un contact de collecteur C.

Le procédé de réalisation décrit ci-après montre comment obtenir un tel transistor dont les contacts d'émetteur et de collecteur sont autoalignés sur les contacts de base, ce qui permet d'obtenir des dimensions tranverses extrêmement faibles, précises et répétitives et donc des transistors de très faibles dimensions et dont les performances sont améliorées. Ce qui fait que la densité d'intégration peut être augmentée et que les performances des circuits sont aussi améliorées. Le procédé de réalisation selon l'invention comprend au moins les étapes suivantes :

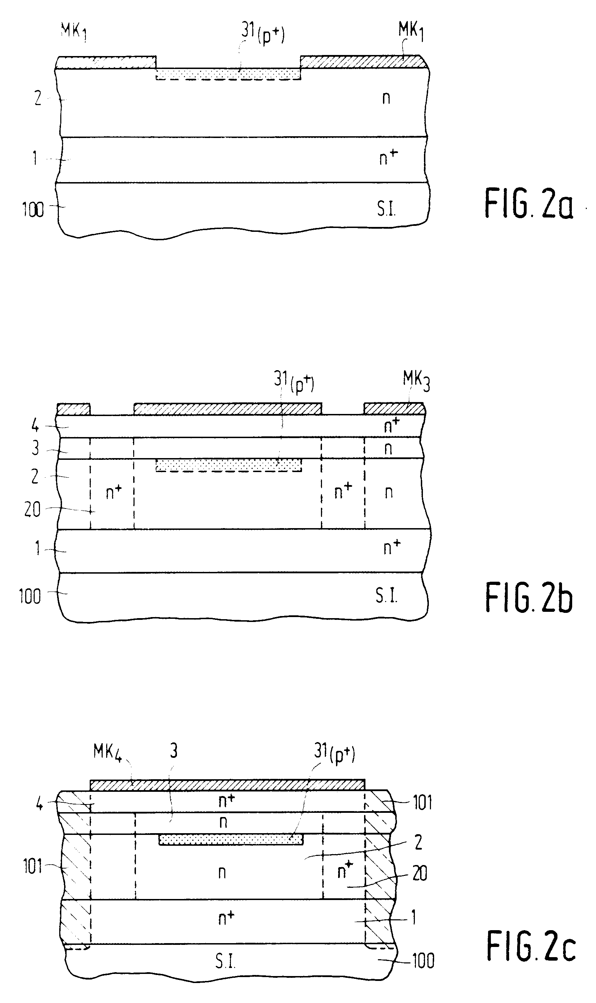

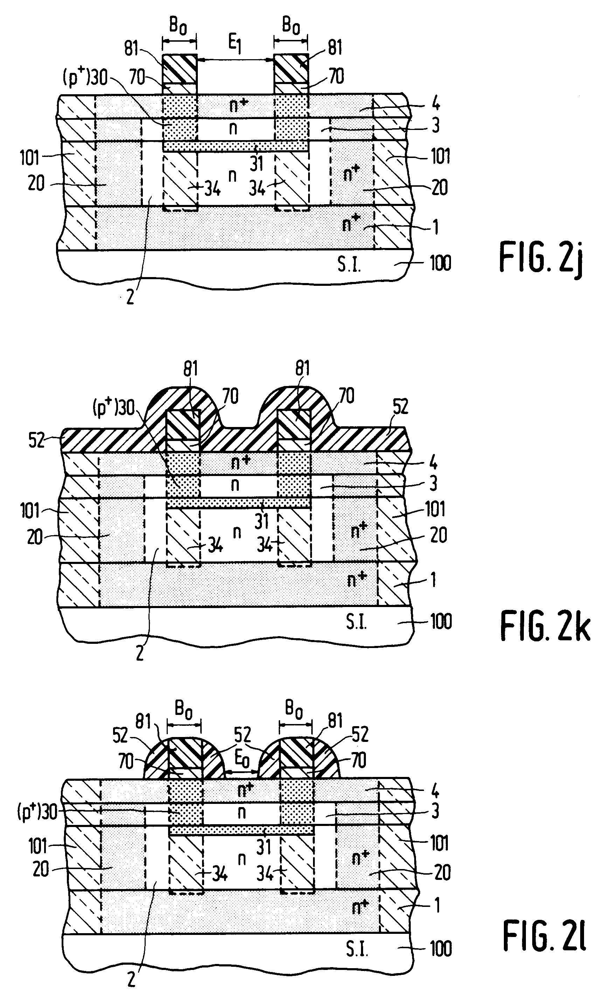

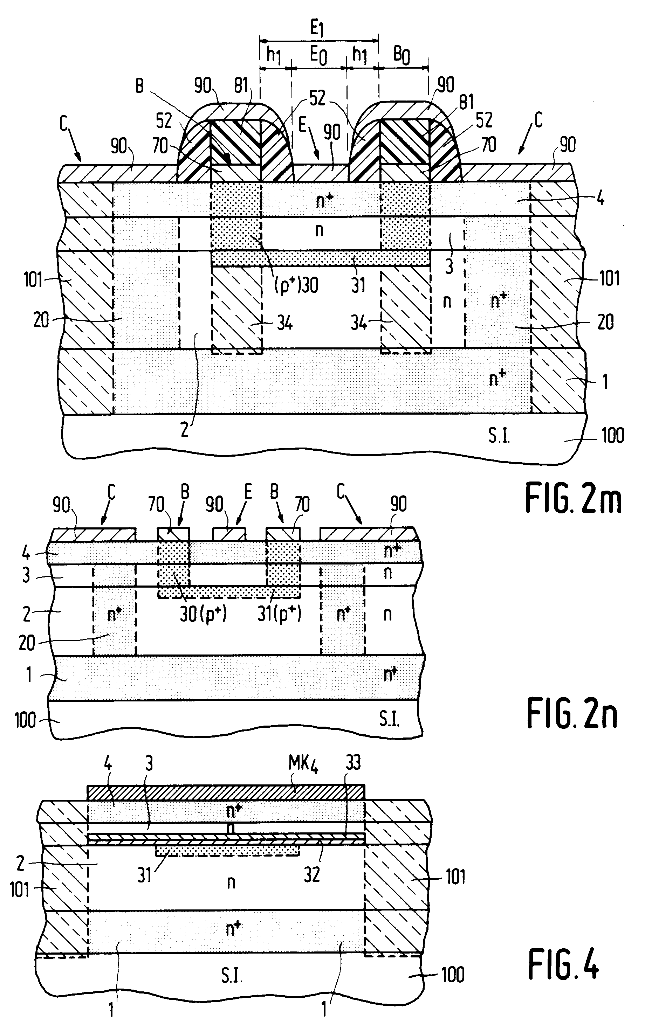

a/ formation d'un substrat 100 en un matériau du groupe III-V monocristallin présentant une face supérieure orientées par exemple selon une direction cristallographique [1 0 0]. Ce substrat est choisi semi-isolant pour que le procédé se trouve en synergie de fabrication avec les procédés de réalisation de circuits intégrés. En effet, le but visé par l'invention est la réalisation de transistors à hétérojonction intégrés et non pas de transistors discrets. Le substrat sera favorablement en arséniure de gallium GaAs, semi-isolant obtenu par exemple par dopage au moyen d'ions fer (Fe). Ce substrat pourra aussi être réalisé en arséniure de gallium dopé à l'indium et recuit, ce qui permet d'obtenir des matériaux dépourvus de dislocations et compatibles avec la croissance ultérieure de couches épitaxiales du groupe III-V,

b/ réalisation de deux couches épitaxiales planes d'arséniure de gallium pour former le collecteur, successivement une couche 1 de type de conductivité $n^+$ et une couche 2 de type de conductivité n. La croissance épitaxiale de ces couches peut être réalisée en phase vapeur ou en phase liquide. Elle sera réalisée de préférence par une méthode au organo-métalliques (MOCVD) ou MBE. La couche 1 présentera une épaisseur de 0,2 à 1 $\mu$m et de préférence 0,5 $\mu$m. Cette couche 1 est de type de conductivité $n^+$ obtenue par exemple par un dopage au moyen de l'ion silicium (Si) à environ 3 à 5.$10^{18}$ ions par cm$^3$ (voir la figure 2a). L'épaisseur optimale de la couche 2 est 0,3 $\mu$m et le type de conductivité n est obtenu par exemple par dopage au moyen de l'ion silicium (Si) à 5.$10^{16}$ ions par cm$^3$ ;

c/ implantation localisée dans la région superficielle de la seconde couche collecteur 2 de porteurs de type p pour former une couche de base 31 de type de conductivité $p^+$ (voir la figure 2a). A cet effet un masque MK$_1$ par exemple en photorésist est réalisé en surface de la couche 2 et une ouverture est pratiquée dans ce masque en surface de la région destinée à constituer la région de base. La couche 31 est réalisée par l'implantation peu profonde (100 nanomètres et moins) d'ions tels que Be, ou Mg ou Zn. On peut également réaliser une co-implantation de phosphore P avec Mg, ou bien de F avec Be, ce qui permet d'améliorer le pourcentage d'activation et de réduire la diffusion lors des traitements thermiques ultérieurs. La concentration des ions implantés sera environ 5.$10^{18}$ cm$^{-3}$,

d/ réalisation de deux couches épitaxiales planes superposées, la première 3 d'un matériau ternaire du groupe III-V, par exemple de l'arséniure de gallium et d'aluminium(GaAlAs), de type de conductivité n formant la couche d'émetteur, et la seconde 4 d'un matériau binaire ou ternaire, par exemple GaAs ou GaInAs de type de conductivité $n^+$ pour la permettre la prise des contacts. La croissance épitaxiale de ces couches sera réalisée par le même procédé choisi pour la croissance des couches 1 et 2 (voir figure 2b). La couche d'émetteur 3 aura une épaisseur de l'ordre de 0,15 $\mu$m et la couche de contact 4 aura une épaisseur de l'ordre de 0,15 $\mu$m. La couche d'émetteur 3 sera dopée à l'aide d'ions par exemple Si à une concentration de l'ordre de 5.$10^{17}$ par cm$^3$ et la couche de contact 4 à l'aide d'ions Si à une concentration de 2.$10^{18}$ par cm$^3$. La couche 3 en arséniure de gallium et d'aluminium (GaAlAs) présentera de préférence une concentration de 0,25 en aluminium,

e/ implantation localisée, dans une région choisie pour former le collecteur, de porteurs de type n à une profondeur appropriée à réaliser des caissons 20 de type $n^+$ reliant la couche 1 d'arséniure de gallium de collecteur de type $n^+$ à la couche 4 d'arséniure de gallium de type $n^+$. Cette implantation sera faite dans l'ouverture d'un masque MK$_3$, à l'aide d'ions par exemple Si, à une concentration de l'ordre de 5.$10^{18}$ par cm$^3$. A l'issue de cette implantation le masque MK$_3$ sera éliminé (voir la figure 2b).

Pour obtenir le profil plat à 5.$10^{18}$ souhaité, on procédera au moyen d'énergies décroissantes.

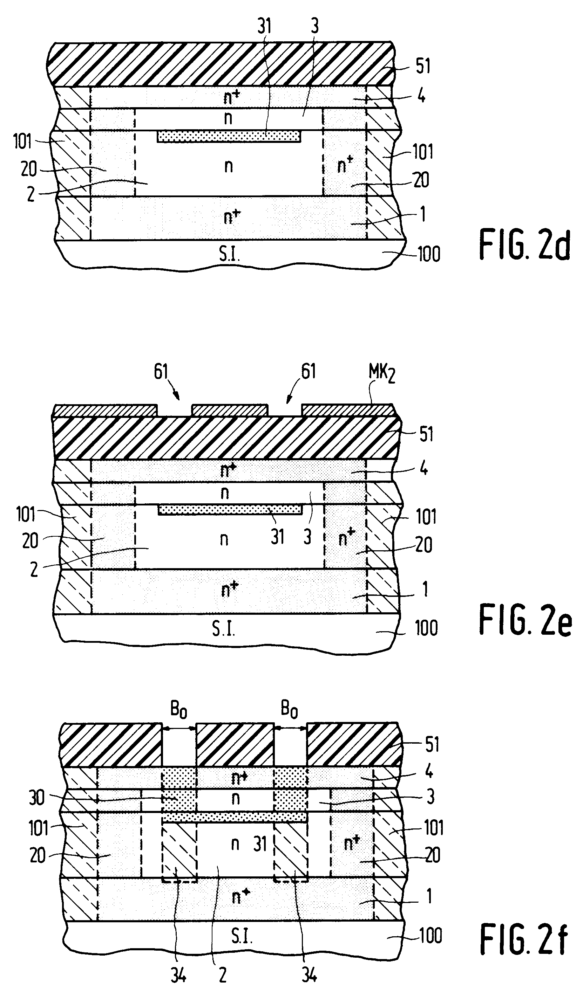

f/ dépôt d'une couche 51 de nitrure de silicium (Si$_3$N$_4$). Ce dépôt est réalisé par dépôt chimique en phase vapeur assisté par plasma (PECVD). Cette couche 51 de nitrure présente favorablement une épaisseur de 0,6 à 1 $\mu$m (voir la figure 2d),

g/ mise en place d'un masque MK$_2$ par exemple en photorésist, délimitant des ouvertures 61 en surplomb des régions de base, et gravure de la couche de nitrure 51 à travers ces ouvertures 61 jusqu'à mettre à nu la surface de la couche d'arséniure de gallium 4. Cette gravure est mise en oeuvre par une méthode permettant d'obtenir des flancs de gravure perpendiculaires au plan des couches par exemple par gravure ionique réactive (RIE) au moyen des gaz CHF$_3$ - SF$_6$ dans le rapport 30 à 1. On forme ainsi, dans la couche 51, des ouvertures de dimensions B$_0$ distantes entre elles d'une valeur E$_1$ (voir les figures 2e et 2f),

h/ implantation localisée de porteurs de type $p^+$ à travers les ouvertures B$_0$ avec une énergie suffisante à atteindre la couche de base 31, pour former des caissons 30 de type $p^+$, reliant la couche de base 31 à la surface de la couche épitaxiale de type $n^{+'}$. Cette implantation est faite comme lors de l'étape c/ au moyen d'ions Mg ou Be. Un profil d'implantation plat est obtenu au moyen d'intensités décroissantes, jusqu'à obtenir une concentration de quelques $10^{19}$ $cm^{-3}$.

Le recuit d'implantation peut être fait à 850°C pendant quelques min à 10 min sous pression d'arsine ($AsH_3$). Mais de préférence le recuit sera du type "FLASH" pour minimiser les phénomènes de diffusion et améliorer l'activation, consistant à porter le dispositif de 900°C pendant 3 secondes par exemple (voir la figure 2f).

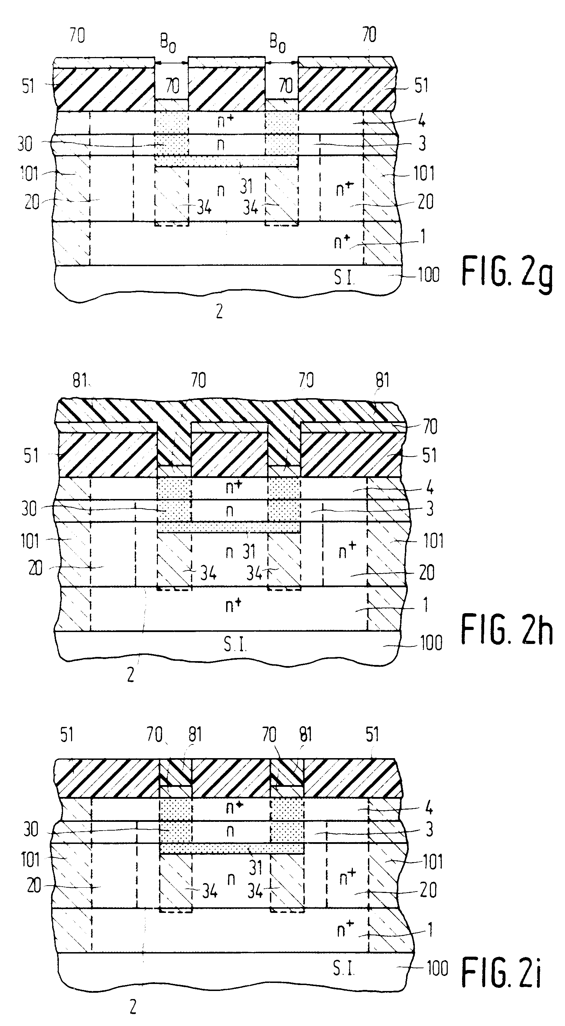

i/ dépôt d'une couche métallique 70 propre à former les contacts de base B (voir la figure 2g).

La couche métallique 70 pourra être favorablement composée d'or-manganèse (Au-Mn) d'or-béryllium (Au-Be), d'or-zinc (Au-Zn), ce sera de préférence Au-Mn à 4 %, qui permet d'obtenir un contact de faible résistivité. Cette couche se dépose non seulement dans les ouvertures $B_0$, mais aussi en surface de la couche de nitrure 51.

j/ Réalisation d'une couche 81 de silice ($SiO_2$) très épaisse, en surface de tout le dispositif (voir la figure 2h) puis planarisation de ce dispositif au niveau supérieur de la couche de nitrure 51.

Cette planarisation se fait en deux étapes. La première étape consiste en la gravure de la couche de silice 81 jusqu'au niveau des métallisations 70 qui recouvrent le nitrure 51. Cette gravure peut être faite par RIE au moyen des gaz $CHF_3$-$O_2$ avec 30 SCCM pour $CHF_3$ et 3 SCCM pour $O_2$. La seconde étape consiste en l'élimination des portions de métallisations 70 qui recouvrent le nitrure 51. Cette élimination se fait par usinage ionique au moyen par exemple d'ions $Ar^+$ (en plasma Argon) à 400-600 eV.

Pour la mise en oeuvre du procédé de planarisation de la couche 81 de silice on lira avec profit la publication : "1984 5-MIC Conference June 21-22" 1984 IEEE intitulée : "Plasma Planarisation with a non-planar sacrificial layer", p.37-44, ou encore "Journal Electrochemical Society Solid State Science and Technology, Vol.133, n°1, January 1986" l'article intitulé : "Two layer planarisation process" par A. SCHITZ and alii p.178-181.

A l'issue de l'étape de planarisation par gravure ionique réactive des couches diélectriques et usinage ionique des parties métalliques 70, il reste le dispositif tel que montré sur la figure 2i où la silice 81 empPAR les ouvertures $B_0$ et est au même niveau supérieur que la couche de nitrure 51.

k/ Gravure sélective du nitrure 51 pour conserver en relief sur le dispositif, les plots de silice 81 qui couvrent les métallisations de base 70, sur l'emplacement des ouvertures $B_0$, ces plots étant distants de $E_1$.

Cette gravure sélective peut être faite par RIE au moyen des gaz $CHF_3$-$SF_6$ avec 30 SCCM pour $CHF_3$ et 1 SCCM pour $SF_6$.

A l'issue de cette étape, on obtient, en relief sur la surface supérieure de la couche 4, des plots de silice 81 couvrant la métallisation 70 de base, dont les flancs sont bien perpendiculaires au plan des couches (voir la figure 2j) et distants de $E_1$.

l/ Réalisation autour des plots de silice 81 d'espaceurs 52 en nitrure de silicium ($Si_3N_4$) (voir les figures 2k et 2l). Ces espaceurs 52 sont réalisés selon une technique décrite dans la publication intitulée "Edge-Defined Patterning of Hyperfine Refractory Metal Silicide MOS Structure" par SHINIJI OKAZAKI dans IEEE Transactions on Electron Devices, Vol.ED-28, n°11, Nov.81, pp.1364-1368. L'application de cette technique à la réalisation du présent dispositif est illustrée figures 3a et 3b. Une couche 52 de matériau diélectrique $Si_3N_4$ est déposée de façon uniforme sur le dispositif et d'une épaisseur très précise $h_1$ choisie pour la dimension des espaceurs. L'épaisseur de la couche 52 est donc $h_1$, l'épaisseur totale des couches 81, 70 et 52 est $h_2$. Il est ensuite pratiqué sur le dispositif une gravure ionique réactive telle qu'une épaisseur identique du matériau 52 est enlevée en chaque point.

L'épaisseur de matériau 52 étant pratiquement égale à $h_2$ le long des flancs de l'ouverture $E_1$ dans la couche 81 (voir figures 3a et 2k) après cette gravure il reste le long de ces flancs une portion de la couche 52 qui y est appuyée et qui a pour dimension latérale $h_1$ obtenue avec une précision $\simeq$ 1 % (voir figures 3b et 2l). Cette portion de couche 52 restante prend le nom "d'espaceur". L'espaceur a pour fonction de modifier la limite d'un masque par exemple. Ici les espaceurs 52 modifient l'ouverture $E_1$ pratiquée dans la couche 81, (voir fig.2j) et sont prévus de manière à laisser subsister une ouverture égale à la longueur $E_0$ d'émetteur souhaitée pour le transistor $E_0 = E_1$-$2h_1$, typiquement une dimension de l'ordre de 0,5 $\mu$m. Cette méthode est extrêmement précise et répétitive contrairement à l'art antérieur.

De plus, les espaceurs 52 vont définir aussi, avec la même précision, la distance $h_1$ entre les contacts de base B de métal 70, et le contact d'émetteur E réalisé ultérieurement ; et la distance entre les contacts de base B et les contacts de collecteur C réalisés ultérieurement.

Dans l'exemple de réalisation décrit ici, l'épaisseur $h_1$ est choisie entre 0,1 et 0,3 $\mu$m.

La gravure de la couche 52 pour obtenir les espaceurs est réalisée de préférence par RIE au moyen des gaz $CHF_3$ (30 SSCM) et $SF_6$ (1 SCCM).

m/ dépôt d'une couche métallique 90 propre à former les contacts d'émetteur E et de collecteur C, les plots de la couche de silice 81 et les espaceurs 52 servant de masque, puis élimination des couches diélectriques de silice 81 et de nitrure de silicium 52. Le contact d'émetteur se forme dans l'ouverture $E_0$, et les contacts de collecteurs se forment de part et d'autre des plots 81 (voir les figures 1b et 2m).

Le métal pour constituer la couche 90 de contact d'émetteur et de collecteur sera avantageusement une multi-couches de l'alliage Au-Ge surmonté d'une couche de nickel (voir la figure 2m). Les métallisations de contacts 90 subissent un recuit à environ 400°C.

Lors du dépôt, la couche métallique 90 a aussi couvert les plots de silice 81 et le nitrure 52 ; cette partie de la couche 90 indésirable sera éliminée par LIFT-OFF lors de l'élimination de la silice et du nitrure, par exemple au moyen d'une solution d'HF tamponnée.

On obtient alors le dispositif du transistor à hétérojonction de la forme planar recherchée (voir la figure 2n). De plus ce dispositif a été obtenu par l'autoalignement des contacts collecteur-émetteur sur les contacts de base en une seule opération consistant la formation d'espaceurs de dimension très précise.

n/ implantation ionique localisée entre les contacts de collecteur C de base B et d'émetteur E servant de masque, d'espèces propres à former des caissons isolants 110 entre ces électrodes pour éviter les courants de fuite, avec une énergie permettant d'atteindre la surface supérieure de la couche 3 d'émetteur de type n. On pourra à cet effet implanter des ions bore (B), oxygène (O), ou bien implanter des protons à une concentration d'environ $2.10^{18}$ $cm^{-3}$ (voir la figure 1a).

Ainsi le dispositif selon l'invention présente différents avantages : tout d'abord l'utilisation d'un substrat semi-isolant en arséniure de gallium permet de se trouver en synergie de réalisation avec d'autres dispositifs tels que les transistors à effet de champ, les diodes etc..., l'utilisation du substrat SI permet aussi d'éliminer les capacités parasites des plots de contacts.

Dans une variante de l'invention le substrat semi-isolant est en arséniure de gallium et d'indium, qui est obtenu directement semi-isolant par recuit, et qui est particulièrement exempt de dislocations comme il est connu de la demande de brevet européen EP-A-0176130.

D'autre part dans cette variante, la couche 1 du collecteur peut être réalisée par implantation ionique par exemple de sélénium (Se) directement dans le substrat semi-isolant 100.

On notera que le fait de réaliser les doigts d'émetteur très étroits permet d'améliorer les performances du dispositif. En effet, le schéma équivalent du transistor HBT montre une résistance en série avec la base et une capacité base-collecteur.

La réponse en fréquence du transistor est déterminée par le produit de la résistance de base par la capacité base-collecteur. La réduction des dimensions du transistor permet de réduire le produit de ces deux facteurs, et par conséquent d'augmenter la réponse en fréquence du transistor. Il s'ensuit que ce dernier montre alors des performances réellement et nettement améliorées par rapport au dispositif connu de l'art antérieur.

Le procédé selon l'invention peut en outre comprendre une étape d'isolation pour délimiter le transistor. A cet effet, une étape d'/ peut être intercalée entre l'étape d/ et l'étape e/.

d'/ Implantation d'ions favorablement $O^+$ dans les ouvertures d'un masque $MK_4$ et qui couvre la zone active (voir la figure 2c) à l'exception de la périphérie du transistor. Les ions sont implantés dans les zones périphériques 101 d'isolement du transistor.

Il est déjà connu de l'état de la technique d'implanter des ions bore (B) pour réaliser l'isolation des zones actives. Ce type d'implantation au bore crée des défauts et permet d'isoler par exemple des couches de type n et p, ce qui est nécessaire lorsque la couche de base est réalisée par épitaxie sur toute la surface du dispositif et n'est pas localisée comme ici, selon l'invention, à une couche 31 parfaitement délimitée.

Ici l'isolation à l'aide d'oxygène est choisie de préférence à l'isolation au bore du fait que, si cette dernière était choisie, son efficacité disparaîtrait lors de recuits à des températures supérieures à 500-600°C. Or de tels recuits supérieurs à 600°C sont utilisés ultérieurement dans le présent procédé.

Ainsi l'isolation au bore n'étant pas nécessaire puisque la couche de base est délimitée par une méthode autre que l'isolation, l'isolation à l'oxygène est au contraire favorable.

Le procédé selon l'invention peut en outre comprendre la réalisation d'une couche destinée à éviter la diffusion des porteurs p de la couche de base 31 vers la couche émetteur 3. A cet effet, ce procédé comprend alors entre l'étape c/ et l'étape d/, une étape c'/ telle que :

c'/ Réalisation d'une couche épitaxiale 32 en surface de la couche 2, en GaAs, non dopée intentionnellement ou faiblement dopée p, de l'ordre de 10 à 20 nm pour éviter la diffusion des porteurs p de la couche 31 vers la couche 3 (voir la figure 4).

Le procédé selon l'invention peut aussi comprendre une étape c'' entre l'étape c'/ et l'étape d/ telle que :

c'' Réalisation d'une couche épitaxiale 33 en GaAlAs présentant un gradient de composition en Al de 0 à 25 % de façon à obtenir une hétérojonction graduelle entre l'émetteur et la base, ce qui permet d'obtenir un meilleur gain en courant (voir la figure 4).

Le procédé selon l'invention peut aussi comprendre entre l'étape g/ et l'étape h/ une étape g'/ telle que :

g'/ Implantation dans les ouvertures $B_0$ d'ions oxygène pour des zones d'isolement 34 sous les zones de base extrinsèques et ainsi réduire la capacité base-collecteur, permettant alors d'améliorer la réponse en fréquence du transistor. La concentration favorable en oxygène implanté sera de $5.10^{16}$ cm$^{-3}$ à $5.10^{18}$ cm$^{-3}$. La profondeur d'implantation sera dans la zone entre la couche 31 et la couche 1 (voir la figure 2f).

La figure 1b représente vu du dessus un exemple de réalisation du dispositif. La ligne en trait discontinu représente les bords du masque MK$_4$ qui couvrait la zone active durant l'étape d'/ et qui délimite de ce fait cette zone active.

D'autres formes du transistor sont possibles et notamment de nombreuses autres configurations des électrodes sans sortir du cadre de la présente invention.

Enfin au lieu de réaliser l'isolation de la zone active lors de l'étape d'/, cette isolation peut être réalisée lors d'une ultime étape m'/ par implantation de protons ou bore autour d'un masque couvrant la zone active du transistor.

Des valeurs préférentielles pour les différentes dimensions mises en oeuvre dans le procédé sont données ci-dessous :

$B_0$ = 1 à 2 $\mu$m
$E_1$ = 0,9 à 1,6 $\mu$m
$h_1 \simeq$ 0,2 à 0,3 $\mu$m
$E_0 \simeq$ 0,5 à 1 $\mu$m

On peut aussi réaliser la couche de base dans une variante de l'invention en remplaçant l'étape c/, connue de l'état de la technique, par une étape $c_0$/ telle que :

$c_0$/ Réalisation d'une couche épitaxiale 31' en un matériau binaire du groupe III-V de type de conductivité p$^+$ pour former une couche de base, suivie d'une gravure, autour d'un masque définissant la zone de base, jusqu'au niveau supérieur de la couche collecteur 2. La gravure peut être faite par voie sèche ou humide. La zone de base 31' se trouve alors en relief sur la couche collecteur 2. Le procédé est repris comme précédemment. L'épaisseur de la couche p$^+$ 31' est de l'ordre de 0,1 $\mu$m. Le dispositif obtenu est donc quasi-planaire.

D'autres matériaux III-V peuvent être envisagés pour réaliser le transistor, pourvu que les conditions nécessaires à l'obtention des hétérojonctions soient respectées.

## Revendications

1. Procédé de réalisation d'un dispositif semiconducteur du type transistor bipolaire à hétérojonction à structure planaire, ce procédé comprenant au moins la réalisation d'une structure comportant successivement au moins une couche de collecteur (1, 2) d'un premier type de conductivité, une couche de base (31) du second type de conductivité opposé au premier, une couche d'émetteur (3) du premier type de conductivité, une couche de contact (4) fortement dopée du premier type de conductivité et des caissons (20) du premier type du conductivité reliant la couche de collecteur à la couche de contact, caractérisé en ce qu'il comprend en outre les étapes de :

   a/ dépôt d'une couche (51) de nitrure de silicium (Si$_3$N$_4$),
   b/ mise en place d'un masque (MK$_2$) délimitant des ouvertures (61) au dessus des zones de base destinées à former la base extrinsèque et gravure de la couche de nitrure à travers ces ouvertures jusqu'à mettre à nu la surface de la couche de contact par une méthode permettant d'obtenir des flancs de gravure perpendiculaires au plan des couches, formant ainsi des ouvertures ($B_0$) dans la couche de nitrure, éloignées l'une de l'autre,
   c/ implantation localisée de porteurs du second type de conductivité à travers les ouvertures avec une énergie suffisant à atteindre la couche de base, pour former des caissons (30) du second type de conductivité reliant la couche de base à la surface de la couche de contact,
   d/ dépôt d'une couche métallique (70) s'établissant dans les ouvertures pour former les contacts de base, ainsi que sur les parties restantes de la couche de nitrure,
   e/ réalisation d'une couche (81) de silice (SiO$_2$), épaisse, puis planarisation du dispositif ainsi obtenu jusqu'au niveau supérieur de la couche de nitrure, par gravure ionique réactive et usinage ionique,

f/ gravure sélective des parties restantes de la couche de nitrure pour conserver des plots de silice couvrant les métallisations de base,

g/ dépôt d'une nouvelle couche (52) de nitrure de silicium et formation par une méthode connue en soi, d'espaceurs du matériau appuyés contre les flancs des plots de silice pour délimiter entre ces plots une ouverture ($E_0$) définissant la largeur du contact d'émetteur, ces espaceurs définissant aussi les distances des électrodes (C, B, E) de collecteur, base et émetteur entre elles,

h/ dépôt d'une couche métallique (90) propre à former les contacts d'émetteur et de collecteur, les plots de silice et les espaceurs servant de masque, puis élimination de ces parties diélectriques,

i/ implantation localisée entre les contacts de collecteur, base, et émetteur servant de masques, d'espèces propres à former des caissons isolants (110) entre ces électrodes et avec une énergie permettant d'atteindre la surface supérieure de la couche d'émetteur du premier type de conductivité.

2. Procédé selon la revendication 1, caractérisé en ce que la structure des couches de collecteur, de base et d'émetteur est formée sur un substrat semi-isolant, et en ce que dans cette structure :

- le collecteur est constitué par la superposition de deux couches binaires (1, 2) du premier type de conductivité dont la première (1) est fortement dopée,
- la couche de base (31) est réalisée par une implantation localisée d'ions du second type de conductivité dans la région superficielle de la seconde couche collecteur (2),
- des caissons (20) reliant la première couche de collecteur (1) à la couche de contact (4) sont réalisés par une implantation localisée, dans une région choisie pour former le collecteur, d'ions du premier type de conductivité.

3. Procédé selon la revendication 1 ou 2, caractérisé en ce que le transistor est isolé par une implantation d'ions propres à former des régions d'isolement (101) délimitant la zone active du transistor, cette dernière étant masquée durant cette opération.

4. Procédé selon l'une des revendications précédentes, caractérisé en ce qu'entre la couche de base (31) en matériau binaire et la couche d'émetteur (3) en matériau ternaire, une couche en matériau (32) binaire, non dopée intentionnellement est réalisée pour éviter la diffusion des porteurs de la couche binaire de base vers la couche ternaire d'émetteur.

5. Procédé selon la revendication 4, caractérisé en ce qu'entre la couche binaire (32) non dopée intentionnellement et la couche ternaire d'émetteur (3) on réalise une couche ternaire (33) présentant un gradient de composition pour obtenir une hétérojonction graduelle entre l'émetteur et la base.

6. Procédé selon l'une des revendications précédentes, caractérisé en ce qu'entre l'étape b) et l'étape c), il comprend une étape b$'$) telle que :

b$'$) implantation dans les ouvertures ($B_0$) d'ions propres à créer des zones d'isolement (34) sous les régions extrinsèques de base.

7. Procédé selon l'une des revendications 4 ou 5, caractérisé en ce que :

- le substrat (100) est en arséniure de gallium (GaAs) semi-isolant orienté selon une direction cristallographique [100] ;
- les couches binaires sont en arséniure de gallium (GaAs) ;
- les couches ternaires sont en arséniure de gallium et d'aluminium (GaAlAs), présentant éventuellement un gradient de composition de l'élément Al lorsque ce gradient est prévu ;
- le premier type de conductivité est le type n ;
- le second type de conductivité opposé est le type p.

8. Procédé selon la revendication 7, caractérisé en ce que, pour obtenir le type de conductivité $n^+$ ou n les couches sont dopées à l'aide d'ions $Si^+$.

9. Procédé selon l'une des revendications 7 ou 8, caractérisé en ce que pour obtenir des caissons de type de conductivité $n^+$, l'implantation ionique prévue est réalisée au moyen d'ions $Si^+$.

10. Procédé selon l'une des revendications précédentes, caractérisé en ce que pour obtenir des zones de type de conductivité $p^+$, l'implantation ionique prévue est réalisée au moyen d'ions choisis parmi Be, Mg, Zn, et parmi une association de F avec Be, ou P avec Mg.

**11.** Procédé selon l'une des revendications précédentes, caractérisé en ce que la couche métallique (70) déposée lors de l'étape d) pour former les contacts de base est choisie parmi les composés Au-Mn, Au-Be, Au-Zn, et en ce que la couche métallique (90) déposée lors de l'étape h) pour former les contacts d'émetteur et collecteur est une multicouche d'Au-Ge surmontée de Ni.

**12.** Procédé selon l'une des revendications 3 ou 6, caractérisé en ce que pour former les zones isolantes (101, 34), il est implanté des ions oxygène ($O^+$).

**13.** Procédé selon l'une des revendications précédentes, caractérisé en ce que pour former les zones isolantes (110) entre les électrodes, lors de l'étape i), il est implanté des éléments choisis parmi des ions B, des ions $O^+$, et des protons.

**14.** Procédé selon l'une des revendications précédentes, caractérisé en ce que la couche de base est une couche additionnelle en un matériau binaire du groupe III-V du second type de conductivité avec une gravure, autour d'un masque définissant la zone de base, jusqu'au niveau supérieur de la couche collecteur.

**Claims**

**1.** A method of manufacturing a semiconductor device of the hetero-junction bipolar transistor type having a planar structure, this method comprising at least the realization of a structure comprising successively at least a collector layer (1, 2) of a first conductivity type, a base layer (31) of a second conductivity type opposed to the first, an emitter layer (3) of the first conductivity type, a highly doped contact layer (4) of the first conductivity type, and islands (20) of the first conductivity type connecting the collector layer to the contact layer, characterized in that it in addition comprises the steps of:

a/ depositing a layer (51) of silicon nitride ($Si_3N_4$);

b/ positioning a mask ($MK_2$) defining openings (61) above base zones destined to form the extrinsic base and etching the layer of silicon nitride through these openings until the surface of the contact layer is exposed by a method which permits of obtaining etching flanks perpendicular to the plane of the layers, thus forming in the nitride layer openings ($B_0$) which are spaced apart from each other;

c/ localized implantation of carriers of the second conductivity type through the openings with an energy sufficient to attain the base layer so as to form islands (30) of the second conductivity type connecting the base layer to the surface of the contact layer;

d/ depositing a metal layer (70) formed in the openings for forming the base contacts as well as on the remaining portions of the nitride layer;

e/ forming a thick layer (81) of silica ($SiO_2$) and then planarizing the device thus obtained by a known method down to the upper level of the nitride layer through reactive ion etching and ion blasting;

f/ Selectively etching the remaining portions of the nitride layer to maintain bond pads of silica covering the base metallizations;

g/ depositing a fresh layer (52) of silicon nitride and forming by a known method spacers from the material, which spacers bear on the flanks of the silica bond pads for defining an opening ($E_0$) between these bond pads which defines the width of the emitter contact, these spacers also defining the distances between the collector, base and emitter electrodes (C, B, E);

h/ depositing a metal layer (90) suitable to form the emitter and collector contacts, the silica bond pads and the spacers serving as masks, and then eliminating these dielectric parts;

i/ localized ion implantation between the collector, base and emitter contacts serving as masks of elements suitable to form insulating islands (110) between these electrodes and with an energy permitting of attaining the upper surface of the emitter layer of the first conductivity type.

**2.** A method as claimed in Claim 1, characterized in that the structure of the collector, base and emitter layers is formed on a semi-insulating substrate and in that in said structure:

- the collector is formed by the superposition of two binary layers (1, 2) of the first conductivity type, of which the first (1) is highly doped;
- the base layer (31) is realized by a localized implantation of ions of the second conductivity type into the surface region of the second collector layer (2);

- islands (20) connecting the first collector layer (1) to the contact layer (4) are realized by a localized implantation, into a region chosen to form the collector, of ions of the first conductivity type.

3. A method as claimed in Claim 1 or 2, characterized in that the transistor is insulated by an implantation of ions suitable for forming insulation regions (101) defining the active zone of the transistor, the latter zone being masked during this operation.

4. A method as claimed in any one of the preceding Claims, characterized in that a not intentionally doped layer (32) of binary material is provided between the base layer (31) of binary material and the emitter layer (3) of ternary material in order to prevent the diffusion of carriers from the binary base layer to the ternary emitter layer.

5. A method as claimed in Claim 4, characterized in that a ternary layer (33) having a composition gradient is provided between the not intentionally doped binary layer (32) and the ternary emitter region (3) so as to obtain a gradual hetero-junction between the emitter and the base.

6. A method as claimed in any one of the preceding Claims, characterized in that between the step b) and the step c) a step b') is included. *i.e.*:
    b') implantation through the openings ($B_0$) of ions suitable for producing insulation zones (34) under the extrinsic base zones.

7. A method as claimed in Claim 4 or 5, characterized in that:
    - the substrate (100) consists of semi-insulating gallium arsenide (GaAs) orientated in a crystallographic direction [100],
    - the binary layers consist of gallium arsenide (GaAs),
    - the ternary layers (3) consist of gallium-aluminium arsenide (GaAlAs), possibly having a gradient in its content of the element Al if such a gradient is envisaged,
    - the first conductivity type is the n type,
    - the second opposed conductivity type is the p type.

8. A method as claimed in Claim 7, characterized in that, in order to obtain the $n^+$ or n conductivity type, the layers are doped by means of $Si^+$ ions.

9. A method as claimed in Claim 7 or 8, characterized in that, in order to obtain islands of the $n^+$ conductivity type, the ion implantation provided is effected by means of $Si^+$ ions.

10. A method as claimed in any one of the preceding Claims, characterized in that, in order to obtain zones of the $p^+$ conductivity type, the ion implantation provided is effected by means of ions chosen from among Be, Mg, Zn and from among an association of F with Be, or P with Mg.

11. A method as claimed in any one of the preceding Claims, characterized in that the metal layer (70) deposited during the step d/ for forming the base contacts is chosen from among the compounds Au-Mn, Au-Be, Au-Zn, and in that the metal layer (90) deposited during the step h/ for forming the emitter and collector contacts is a multi-layer of Au-Ge with Ni disposed thereon.

12. A method as claimed in Claim 3 or 6, characterized in that oxygen ($O^+$) ions are implanted for forming the insulating zones (101, 34).

13. A method as claimed in any one of Claims 6 to 11, characterized in that elements chosen from among B ions, $O^+$ ions and protons are implanted in order to form the insulating zones (110) between the electrodes, during the step i.

14. A method as claimed in any one of the preceding Claims, characterized in that the base layer is an additional layer of a binary material from the III-V group of the second conductivity type etched around a mask defining the base zone down to a level which is higher than the collector layer.

**Patentansprüche**

1. Verfahren zum Herstellen einer Halbleiteranordnung vom bipolaren Transistortyp mit einer planaren Heteroübergangsstruktur, wobei dieses Verfahren mindestens die Herstellung einer Struktur umfaßt, die nacheinander mindestens eine Kollektorschicht (1,2) vom ersten Leitungstyp, eine Basisschicht (31) vom zweiten dem ersten entgegengesetzten Leitungstyp, eine Emitterschicht (3) vom ersten Leitungstyp, und eine stark dotierte Kontaktschicht (4) vom ersten Leitungstyp aufweist sowie Inseln (20) vom ersten Leitungstyp, welche die Kollektorschicht mit der Kontaktschicht verbinden, dadurch gekennzeichnet, daß dieses Verfahren weiterhin die nachfolgenden Verfahrensschritte aufweist:

a/ das Niederschlagen einer Siliziumnitridschicht ($Si_3N_4$),

b/ das Anbringen einer Maske ($MK_2$), die Öffnungen (61) begrenzt, über den Basiszonen, die dazu bestimmt sind, die äußere Basis zu bilden, und das Ätzen der Nitridschicht durch diese Öffnungen hindurch bis zum Freilegen der Oberfläche der Kontaktschicht mit Hilfe eines Verfahrens, durch das Ätzflanken senkrecht zu der Ebene der Schichten erhalten werden, die ebenfalls in einem Abstand voneinander liegende Öffnungen ($B_0$) in der Nitridschicht bilden,

c/ das örtliche implantieren von Trägern vom zweiten Leitungstyp durch die Öffnungen hindurch mit einer Energie, die ausreicht zum Erhalten der Basisschicht, zum Bilden von Inseln (30) vom zweiten Leitungstyp, welche die Basisschicht mit der Oberfläche der Kontaktschicht verbinden,

d/ das Niederschlagen einer metallischen Schicht (70) und zwar in den Öffnungen zum Bilden der Basiskontakte, sowie auf den restlichen Teilen der Nitridschicht,

e/ das Anbringen einer dicken Siliziumdioxidschicht ($SiO_2$) (81) nach Planierung der auf diese Weise erhaltenen Anordnung bis zum oberen Pegel der Nitridschicht durch reaktive Ionenätzung und Ionenbearbeitung,

f/ das selektive Ätzen der restlichen Teile der Nitridschicht zum Erhalten der Siliziumtüpfel, welche die Basismetallisierungen bedecken,

g/ das Niederschlagen einer neuen Siliziumnitridschicht (52) und das mit Hilfe eines an sich bekannten Verfahrens Bilden von Distanzelemente aus Material, das an den Flanken der Siliziumtüpfel angebracht worden ist um zwischen diesen Tüpfeln eine Öffnung ($E_0$) zu begrenzen, wodurch die Größe des Emitterkontaktes definiert wird, wobei diese Distanzelemente ebenfalls die Abstände der Kollektorelektroden, Basiselektroden und Emitterelektroden (C, B, E) untereinander definieren,

h/ das Niederschlagen einer metallischen Schicht (90), die dazu geeignet ist, die Emitter- und die Kollektorkontakte zu bilden, wobei die Siliziumtüpfel und die Distanzelemente als Maske dienen, und danach das Entfernen dieser dielektrischen Teile,

i/ das zwischen den Kollektor-, Basis- und Emitterkontakten die als Maske dienen örtliche Implantieren von Elementen, die dazu geeignet sind zwischen diesen Elektroden isolierende Inseln (110) zu bilden, und mit einer Energie, durch die es möglich ist, die obere Fläche der Emitterschicht vom ersten Leitungstyp zu erreichen.

2. Verfahren nach Anspruch 1, dadurch gekennzeichnet, daß die Struktur der Kollektor-, Basis- und Emitterschichten auf einem halbisolierenden Substrat gebildet ist, und daß in dieser Struktur:

- der Kollektor durch die Überlagerung zweier Binärschichten (1,2) vom ersten Leitungstyp, von denen die erste (1) stark dotiert ist,
- die Basisschicht (31) durch eine örtliche Implantierung von Ionen vom zweiten Leitungstyp in der Oberflächenschicht der zweiten Kollektorschicht (2) gebildet ist,
- die Inseln (20), welche die erste Kollektorschicht (1) mit der Kontaktschicht (4) verbinden, durch eine örtliche Implantierung von Ionen vom ersten Leitungstyp in einem Gebiet, das zum Bilden des Kollektors gewählt worden ist, gebildet sind.

3. Verfahren nach Anspruch 1 oder 2, dadurch gekennzeichnet, daß der Transistor durch eine Implantierung von Ionen isoliert ist, die dazu geeignet sind, Isoliergebiete (101) zu bilden, welche die aktive Zone des Transistors begrenzen, wobei diese letztere während dieses Verfahrensschrittes maskiert wird.

4. Verfahren nach einem der vorstehenden Ansprüche, dadurch gekennzeichnet, daß zwischen der Basisschicht (31) aus binärem Material und der Emitterschicht (3) aus ternärem Material eine vorsätzlich nicht dotierte Schicht aus binärem Material (32) angebracht wird um die Diffusion der Träger der binären Basisschicht zu der ternären Emitterschicht zu vermeiden.

5. Verfahren nach Anspruch 4, dadurch gekennzeichnet, daß zwischen der vorsätzlich nicht dotierten binären Schicht (32) und der ternären Emitterschicht (3) eine ternäre Schicht (33) vorgesehen wird, die einen Zusammensetzungsgradienten aufweist um zwischen dem Emitter und der Basis einen graduellen Heteroübergang zu erhalten.

**6.** Verfahren nach einem der vorstehenden Ansprüche, dadurch gekennzeichnet, daß es zwischen dem Verfahrensschritt b/ und dem Verfahrensschritt c/ einen Verfahrensschritt b'/ gibt, wie:

b'/ das in den Öffnungen ($B_0$) Implantieren von Ionen, die dazu geeignet sind, unterhalb der äußeren Basisgebiete Isolierzonen (34) zu bilden.

**7.** Verfahren nach einem der Ansprüche 4 oder 5, dadurch gekennzeichnet, daß:

- das Substrat (100) aus einem halbisolierenden Galliumarsenid (GaAs) besteht, das entsprechend der kristallographischen Richtung [100] orientiert ist;
- die binären Schichten aus Galliumarsenid (GaAs) bestehen;
- die ternären Schichten aus Gallium-Aluminiumarsenid)GaAlAs) bestehen, die ggf. einen Zusammensetzungsgradienten des Elementes Al darstellen, wenn dieser Gradient vorgesehen ist;
- der erste Leitungstyp der n-Typ ist;
- der zweite entgegengesetzte Leitungstyp der p-Typ ist.

**8.** Verfahren nach Anspruch 7, dadurch gekennzeichnet, daß zum Erhalten des $n^+$- oder n-Leitungstyps die Schichten mit Hilfe von $Si^+$-Ionen dotiert sind.

**9.** Verfahren nach einem der Ansprüche 7 oder 8, dadurch gekennzeichnet, daß zum Erhalten von Inseln vom $N^+$-Leitungstyp die vorgesehene Inonenimplantation mit Hilfe von $Si^+$-Ionen durchgeführt wird.

**10.** Verfahren nach einem der vorstehenden Ansprüche, dadurch gekennzeichnet, daß zum Erhalten $p^+$-leitender Zonen die vorgesehene Ionenimplantation mit Hilfe von Ionen durchgeführt wird, die gewählt worden sind aus Be, Mg, Zn, und aus einer Zusammensetzung von F mit Be, oder P mit Mg.

**11.** Verfahren nach einem der vorstehenden Ansprüche, dadurch gekennzeichnet, daß die während des Verfahrensschrittes d/ angebrachte metallische Schicht (70) zum Bilden der Basiskontakte aus den Zusammensetzungen Au-Be, Au-Zn gewählt worden ist, und daß die während des Verfahrensschrittes h/ angebrachte metallische Schicht (90) zum Bilden der Emitter- und Kollektorkontakte eine auf Ni angebrachte Au-Ge-Mehrschicht ist.

**12.** Verfahren nach einem der Ansprüche 3 oder 6, dadurch gekennzeichnet, daß zum Bilden der Isolierzonen (101, 34) Sauerstoffionen ($O^+$) implantiert werden.

**13.** Verfahren nach einem der vorstehenden Ansprüche, dadurch gekennzeichnet, daß zum Bilden der Isolierzonen (110) zwischen den Elektroden während des Verfahrensschrittes i/ Elemente implantiert werden, gewählt aus Ionen B, Ionen $O^+$ und Protonen.

**14.** Verfahren nach einem der vorstehenden Ansprüche, dadurch gekennzeichnet, daß die Basisschicht eine zusätzliche Schicht aus einem binären Material der Gruppe III-V vom zweiten Leitungstyp ist mit einer Ätzung um eine die Basiszone begrenzende Maske bis zu dem oberen Pegel der Kollektorschicht.

**FIG.1a**

**FIG.1b**

**FIG. 3a**

**FIG. 3b**

FIG. 2a

FIG. 2b

FIG. 2c

FIG. 2d

FIG. 2e

FIG. 2f

FIG. 2g

FIG. 2h

FIG. 2i

FIG. 2j

FIG. 2k

FIG. 2l

FIG. 2m

FIG. 2n

FIG. 4